# EUROPEAN PATENT APPLICATION

(11) **EP 2 882 097 A1**
(43) Date of publication of application: **10.06.2015**
(21) Application number: 13306682.9
(22) Date of filing: 09.12.2013
(51) Int. Cl.: H03F 1/02

(54) **Method for optimizing operation of a doherty amplifier and doherty amplifier**

(71) Applicant: ALCATEL LUCENT, 92100 Boulogne-Billancourt (FR)
(72) Inventor: Wantiez, Eric, 91620 NOZAY (FR); Galiez, Jean-Luc, 91620 NOZAY (FR)
(74) Representative: Novagraaf Technologies

(57) **Abstract**

The invention relates to a method for optimizing operation of a Doherty amplifier (1), the Doherty amplifier comprising a main amplification path (2) and an auxiliary amplification path (3) and being adapted to receive an input signal (5) and split the signal between the main and the auxiliary amplification paths (2, 3) such that the split signals have amplitude and phase differences with respect to each other, the method comprising the steps of:
i) determining (10) tuning sets for several frequency values and several average output power values, each tuning set comprising an amplitude difference and a phase difference for which at least a first and a second performance indicators of the Doherty amplifier (1) are simultaneously optimized;
ii) storing (20) the determined tuning sets in a lookup table in the Doherty amplifier (1); and
iii) automatically setting (30) the phase and amplitude differences between the main and auxiliary amplification paths (2, 3) during operation of the Doherty amplifier (1) using a stored tuning set corresponding to the input signal frequency and a requested average output power.

## Description

### TECHNICAL FIELD

The present invention relates to field of radio frequency power amplifiers. More particularly, the invention concerns the operation of a Doherty amplifier.

### BACKGROUND

Radio frequency (RF) power amplifiers are extensively used in modern communication systems, and more particularly, in wireless communication transmitters like base stations of cellular communications networks.

Doherty amplifiers are particularly adapted for high power RF applications. Doherty amplifiers typically comprise two parallel amplification paths for a modulated input signal. The main amplification path includes a main amplifier operating in class AB mode, and the auxiliary amplification path includes a peak amplifier working in class C mode. A power divider splits the input signal, either with equal power or asymmetrically, to the main and auxiliary amplification paths. A special output power combiner recombines the paths to ensure correct load modulation, which is the basis of the Doherty principle. For load balancing optimization, each path includes a quarter-wave section matched to a common center frequency. During high signal peaks of the input signal, the main amplifier saturates, and the peak amplifier takes over. A digital predistortion (DPD) system may compensate for poor linearity of the power amplifier in open loop occurring with a saturated main amplification stage and the use of an auxiliary class C stage by applying correction factors to the signal to be amplified. Doherty amplifiers with DPD provide for high efficiency and good linearity.

Input and output matching circuits participate in phase and magnitude alignment of the split signal before amplification and the combined signal after amplification, which can be used to shift in positive or negative manner the efficiency, output power, and linearity of the power amplifier.

As the power amplifier is the most energy demanding component in a radio transmission line, energy efficiency is an important parameter which has to be taken into account while sticking to increased linearity requirements at the same time. During the design of the power amplifier, the phase and amplitude (or magnitude) difference settings between the main and auxiliary amplification paths are determined depending on specific application constraints, such as the radio transmission standard defining a signal type, a frequency range and bandwidth, as well as the desired trade-off between amplification efficiency and linearity. The phase and amplitude difference settings are fixed once the fabrication of the power amplifier is completed.

However, the characteristics of the signal to be amplified may vary during the operation or the lifetime of the power amplifier. For example, the frequency channel, the instantaneous bandwidth, and the power level of the signal may change over time, whereas the average output power, the efficiency, and the linearity of the amplifier need to be constant. Further, unit-to-unit or batch-to-batch analog component tolerances as well as temperature and other environmental conditions may alter hardware behavior, for example that of the transistors, and thus lead to decreased power, linearity, and efficiency characteristics of the power amplifier.

Digital Doherty amplifiers have an architecture based on digital amplitude distribution and digital phase alignment, which allows for improving the operation ranges of the transistors of the main and peak amplifiers by disposing of hardware limitations. However, RF conditioning of two or more digital branches is very costly and energy consuming.

Advanced Doherty amplification is based on a single transmission (Tx) chain with analog tuning components at the amplifier inputs. This allows for power balancing between the main and peak amplification paths. Nevertheless, operation of advanced Doherty hardware is fixed in the design stage and thus not adaptive to operation variations.

According to the foregoing, there exists a need for optimized, adaptive and flexible tuning of phase and amplitude differences between the main and auxiliary paths of the power amplifier, which is capable to respond to design objectives in terms of power, efficiency, and linearity as well as instantaneous operation conditions of the power amplifier. An automatic optimization of the Doherty amplifier during operation is highly desirable.

### SUMMARY OF EXEMPLARY EMBODIMENTS

Embodiments of the present invention provide a method for optimizing operation of a Doherty amplifier, and a Doherty amplifier configured to operate in an optimized fashion, thereby resolving the above mentioned problems.

According to a first aspect, there is provided a method for optimizing operation of a Doherty amplifier, the Doherty amplifier comprising a main amplification path and an auxiliary amplification path and being adapted to receive an input signal and split the signal between the main and the auxiliary amplification paths such that the split signals have amplitude and phase differences between each other, the method comprising the steps of:
i) determining, for several frequency values and several average output power values, tuning sets comprising an amplitude difference and a phase difference for which at least a first and a second performance indicators of the Doherty amplifier are simultaneously optimized;
ii) storing the determined tuning sets in a lookup table in the Doherty amplifier; and
iii) automatically setting the phase and amplitude differences between the main and auxiliary amplification paths during operation of the Doherty amplifier using a stored tuning set corresponding to the input signal frequency and a requested average output power.

Advantageously, step i) comprises:
iv) measuring values of the first and second performance indicators at sets of coordinates in a system having a phase difference axis and an amplitude difference axis, wherein a set of coordinates is chosen in the center of each of the four quadrants of the system;
v) determining, from the four sets of coordinates, a first set of coordinates with the maximum first performance indicator;
vi) determining a first and a second gradient of the first and second performance indicators, respectively, between the sets of coordinates along the amplitude and phase difference axes;
vii) if the second performance indicator is below a second threshold value at the first set of coordinates, determining a set of adjacent coordinates with the highest second gradient;
viii) reiterating step vii) as long as the second gradient is positive and until a set of coordinates is found for which the first performance indicator is above a first threshold and the second performance indicator is above the second threshold;
ix) if the second performance indicator is above the second threshold value at the first set of coordinates, determining a set of adjacent coordinates with the highest first gradient; and
x) reiterating step ix) as long as the first gradient is positive and until a set of coordinates is found for which the first performance indicator is above the first threshold and the second performance indicator is above the second threshold.

In some embodiments, the first performance indicator may be the amplification efficiency and the second performance indicator may be the linearity of the Doherty amplifier.

In some embodiments, the first performance indicator may be the peak output power and the second performance indicator may be the amplification efficiency of the Doherty amplifier.

Advantageously, the method may further include:
xi) determining a third gradient of the third performance indicator between the sets of coordinates along the amplitude and phase difference axes;
wherein steps viii) and x) are performed as long as the third gradient is positive and until a set of coordinates is found for which the third performance indicator is above a third threshold. In some embodiments, the first performance indicator may be the peak output power, the second performance indicator may be the amplification efficiency, and the third performance indicator may be the linearity of the Doherty amplifier.

Preferably, the linearity is expressed by the inverse of one of the adjacent channel leakage ratio and the spectral emission mask value at a defined offset from the signal frequency.

According to a second aspect, there is provided a Doherty amplifier for amplifying an input signal, comprising:
- a main amplification path, an auxiliary amplification path, and splitting means configured to split the input signal between the main and the auxiliary amplification paths such that the split signals have amplitude and phase differences with respect to each other;
- a lookup table storing tuning sets for several frequency values and several average output power values, each tuning set comprising an amplitude difference and a phase difference for which the amplification efficiency and at least one of the peak output power and the amplification linearity are simultaneously optimized; and
- control means for automatically setting the phase and amplitude differences between the main and auxiliary amplification paths during operation of the Doherty amplifier using a stored tuning set corresponding to the input signal frequency and a requested average output power.

Advantageously, the control means are configured to:
i) measure values of the first and second performance indicator at sets of coordinates in a system having a phase difference axis and an amplitude difference axis, wherein a set of coordinates is chosen in the center of each of the four quadrants of the system;
ii) determine, from the four sets of coordinates, a first set of coordinates with the maximum first performance indicator;
iii) determine a first and a second gradient of the first and second performance indicators, respectively, between the sets of coordinates along the amplitude and phase difference axes;
iv) if the second performance indicator is below a second threshold value at the first set of coordinates, determine a set of adjacent coordinates with the highest second gradient;
v) reiterate step iv) as long as the second gradient is positive and until a set of coordinates is found for which the first performance indicator is above a first threshold and the second performance indicator is above the second threshold;
vi) if the second performance indicator is above the second threshold value at the first set of coordinates, determine a set of adjacent coordinates with the highest first gradient; and
vii) reiterate step vi) as long as the first gradient is positive and until a set of coordinates is found for which the first performance indicator is above the first threshold and the second performance indicator is above the second threshold.

In some embodiments, the first performance indicator may be the amplification efficiency and the second performance indicator may be the linearity of the Doherty amplifier.

In some embodiments, the first performance indicator may be the peak output power and the second performance indicator may be the amplification efficiency of the Doherty amplifier.

Advantageously, the control means are further configured to:
- determine a third gradient of the third performance indicator between the sets of coordinates along the amplitude and phase difference axes;
wherein the control means are configured to perform steps v) and vii) as long as the third gradient is positive and until a set of coordinates is found for which the third performance indicator is above a third threshold.

In some embodiments, first performance indicator may be the peak output power, the second performance indicator may the amplification efficiency, and the third performance indicator may be the linearity of the Doherty amplifier.

Preferably, the linearity is expressed by the inverse of one of the adjacent channel leakage ratio and the spectral emission mask value at a defined offset from the signal frequency.

As used herein, the term "optimized" is to be understood as meaning that the at least two performance indicators are such that their values correspond to the best compromise possible for the respective application or to the designer's demand.

Additional aspects and advantages of methods and devices according to embodiments disclosed herein will be set forth, in part, in the detailed description, figures and any claims which follow, and in part will be derived from the detailed description. It is to be understood that both the foregoing general description and the following detailed description are only exemplary and do not limit the claimed inventions.

### BRIEF DESCRIPTION OF THE DRAWINGS

Exemplary embodiments of methods and devices are described with reference to the accompanying drawings, in which:
Fig. 1 schematically illustrates a Doherty amplifier according to an embodiment of the present invention,
Fig. 2 is a flow diagram of a method according to embodiments of the present disclosure,
Fig. 3 is a flow diagram of steps of the method according to embodiments of the present disclosure,
Fig. 4 illustrates an example of a coordinate system having a phase difference axis and an amplitude difference axis, the coordinate system containing measured values of a performance indicator of the Doherty amplifier, and
Fig. 5 shows an example of a plot of the peak output power calculated as a function of the phase and amplitude differences between the amplifications paths.

### DETAILED DESCRIPTION

The figures and the following description illustrate exemplary embodiments. In the various figures, elements with similar structures and/or functions may be denoted by like reference numerals.

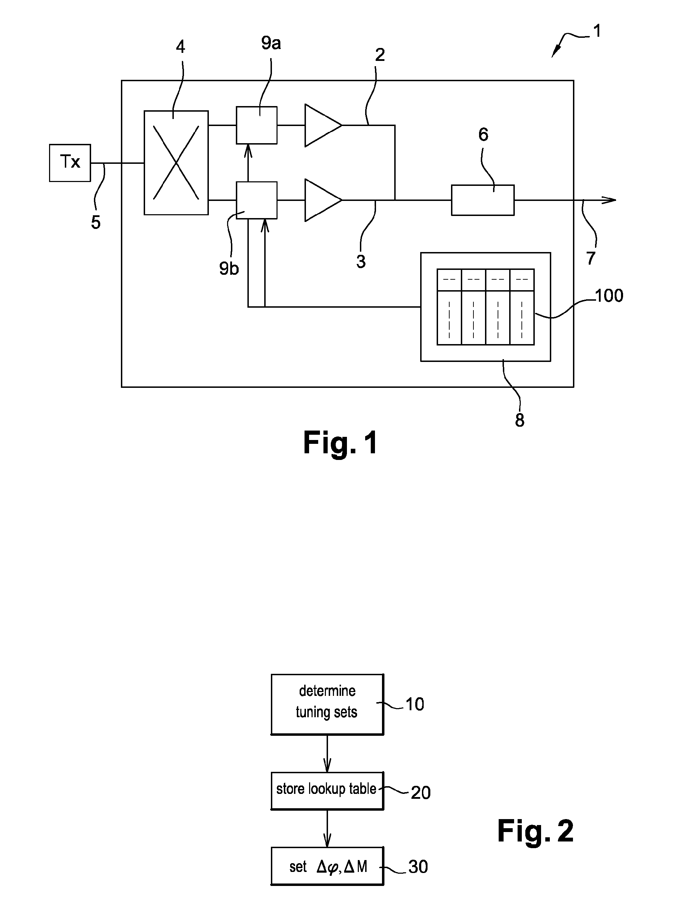

Some embodiments of the present disclosure provide a Doherty amplifier for amplifying an input signal. Fig. 1 is a schematic illustration of such a Doherty amplifier 1. The single-transmission line Doherty amplifier 1 comprises a main amplification path 2, an auxiliary amplification path 3, and splitting means 4 configured to split an input signal 5 between the main and the auxiliary amplification paths 2, 3 such that the split signals have amplitude and phase differences with respect to each other. Recombination means 6 of the Doherty amplifier 1 are configured to recombine the split amplified signals in order to obtain an amplified output signal 7. The Doherty amplifier may comprise further means that are conventionally employed in Doherty architectures, for example, feedback means, digital predistortion means (such as a DPD circuit) and load impedance balancing means (not shown).

The Doherty amplifier 1 according to embodiments disclosed herein comprises a lookup table 100 storing tuning sets for several frequency values and several average output power values, each tuning set comprising an amplitude difference and a phase difference for which at least a first and a second performance indicator are simultaneously optimized.

Some embodiments of the present disclosure provide a method for optimizing operation of a Doherty amplifier. Fig. 2 shows a flow diagram illustrating the method, comprising the following steps.

In a first step 10, tuning sets are determined for several frequency values and several average output power values. As indicated previously, each tuning set comprises an amplitude difference and a phase difference for which at least a first performance indicator and a second performance indicator of the Doherty amplifier are simultaneously optimized. The determining step 10 is performed within the conception/production stage of the Doherty amplifier 1, e.g., on a manufacturing or test bench.

In a second step 20, the determined tuning sets are stored in a lookup table 100 in the Doherty amplifier 1. For example, the lookup table 100 may be stored in a memory of the microcontroller of the Doherty amplifier, as indicated hereinabove.

In a third step 30, the phase and amplitude differences between the main and auxiliary amplification paths are automatically set during operation of the Doherty amplifier using a stored tuning set corresponding to the input signal frequency and a requested average output power.

Again referring to Fig. 1, the Doherty amplifier 1 according to embodiments disclosed herein further comprises control means 8, 9a, 9b configured to implement the automatic setting step 30 during operation of the Doherty amplifier 1, i.e., for automatically setting the phase and amplitude differences between the main and auxiliary amplification paths during operation of the Doherty amplifier 1 using one of the stored tuning sets corresponding to the input signal frequency and a requested average output power. This means that the tuning set providing for optimized operation of the Doherty amplifier 1 is automatically chosen and applied to the amplification paths 2, 3.

As depicted in Fig. 1, the control means may, for example, comprise a microcontroller 8. The microcontroller 8 may include a memory for storing the lookup table 100. The control means may further comprise driving means 9a, 9b arranged in the main and auxiliary amplification paths 2, 3, respectively, in front of the inputs of the amplification stages. The driving means 9a, 9b may be controlled by the microcontroller 8 in order to automatically set the phase and amplitude differences. The driving means 9a, 9b may, for example, be constituted by a digital attenuator and a phase shifter for one or both paths.

The tuning sets each contain an amplitude difference value and a phase difference value, for a given signal frequency value and a given average output power value. As an example, a tuning set may be determined at a nominal average output power (Pᵣₘₛ₋ₙₒₘ), which may be the current requested average output power, and at two adjacent average output power values (for example, Pᵣₘₛ₋ₙₒₘ - 1 dB and Pᵣₘₛ₋ₙₒₘ - 2 dB). For each of these average output power values, tuning sets are determined for several signal frequency values. Similarly as with the average output power, the tuning sets may be determined, for example, for a center frequency value and for adjacent top and bottom frequency values (for example, 1822.5 MHz, 1842.5 MHz, and 1862.5 MHz, respectively, for LTE 20 MHz instantaneous bandwidth application in band 3), the frequency values defining a frequency band contained in the input signal. Examples for frequency bands are band 8 (e.g., downlink 925-960 MHz) or band 1 (e.g., downlink 2110-2170 MHz). The number of tuning sets to be determined depends, amongst others, on the specific design of the Doherty amplifier 1.

The lookup table 100 stored in the Doherty amplifier 1 is thus addressed by the quadruple {amplitude difference, phase difference, frequency, average output power}. During the first step 10 (Fig. 2), while a tuning set is determined for one frequency and one average output power, these two parameters (frequency and average output power) have to remain constant. The average output power may be measured, for example, within the base transceiver station.

The average output power (Pᵣₘₛ) is linked to the input power of the amplifier through the gain of the Doherty amplifier. The gain typically varies with the recombination conditions of the two amplifier paths, i.e., depending on the phase and amplitude differences at the recombination point, and, additionally, as a function of the input frequency and temperature. For one value of the average output power, the input power at the amplification stage can take different values. It is thus necessary to address the lookup table 100 using the average output power. Further, during the first step 10, it may be necessary to regulate the input power at the amplification stage in order to keep the average output power constant.

The tuning set may read, for example, Δϕ= 10°, ΔM = 1.5 dB, and it may be applied to the main amplification path 2 as 0.75 dB and 5° and to the auxiliary amplification path 3 as -0.75 dB and -5°. Alternatively, the paths 2, 3 may be regulated in an asymmetric fashion, or only one of the paths 2, 3 may be regulated with respect to the other one.

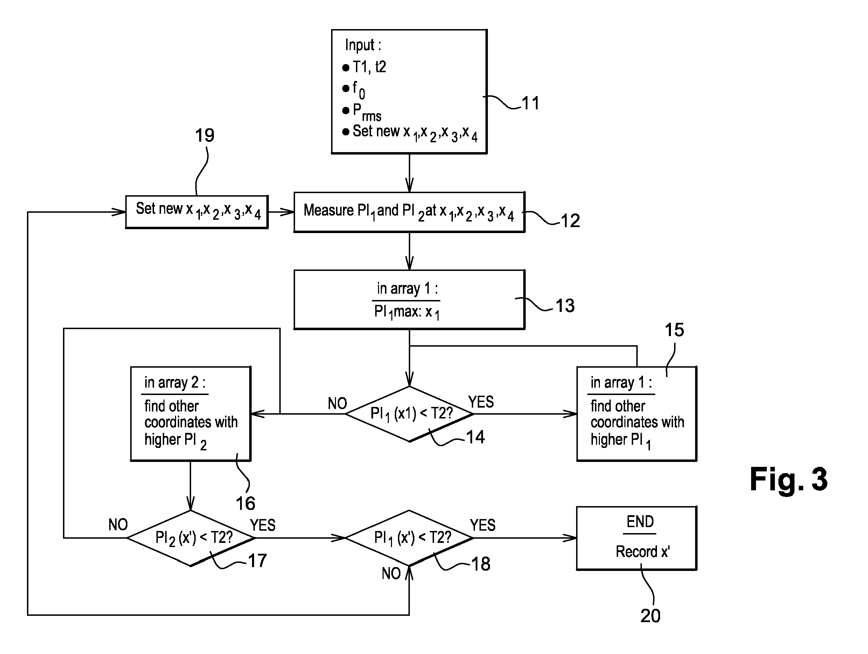

Fig. 3 shows a flowchart of steps of the method according to embodiments of the present invention in more detail. Fig. 3 particularly refers to the determination of the tuning sets and their registration in the lookup table of the Doherty amplifier (determining step 10 and storing step 20, see Fig. 2), performed at the conception/production stage of the Doherty amplifier.

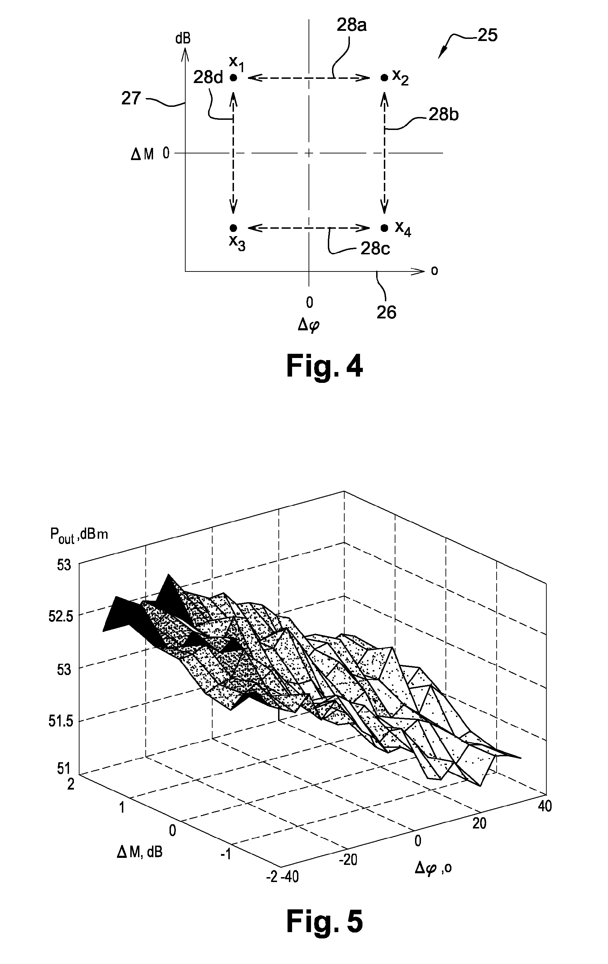

Initially, in step 11, the frequency f₀, the average output power Pᵣₘₛ, first and second thresholds T1, T2 of the first and second performance indicators (PI₁, PI₂), respectively, and sets of coordinates x₁, x₂, x₃, and x₄ are set. The sets of coordinates x₁, x₂, x₃, and x₄ are set in a system having a phase difference axis and an amplitude difference axis, wherein one set of coordinates is chosen in the center of each of the four quadrants of the system. This is illustrated for one of the performance indicators in Fig. 4, showing a coordinate system 25 having a phase difference (Δϕ) axis 26 and an amplitude difference (ΔM) axis 27. The phase difference axis may, for example, cover a range from -40° to +40°, and the amplitude difference axis may, for example, cover a range from -3 dB to +3 dB.

By choosing one set of coordinates in each quadrant, it is advantageously possible to become aware of the coarse appearance of each of the performance indicators within the amplitude-and-phase difference arrays.

In step 12, values of the first and the second performance indicator are measured at the four sets of coordinates x₁, x₂, x₃, and x₄.

In step 13, a first set of coordinates with the maximum first performance indicator is then determined from the four sets of coordinates x₁, x₂, x₃, and x₄. This first set of coordinates may, for example, be x₁.

For both performance indicators, a first and a second gradient are determined between the sets of coordinates x₁, x₂, x₃, and x₄ along the amplitude and phase difference axes (ΔM, Δϕ). Figure 3 schematically illustrates four gradients 28a-28d between x₁, x₂, x₃, and x₄. This allows for knowing the tendencies of each of the performance indicators to increase or to decrease.

Still referring to Fig. 3, in step 14, it is decided if the second performance indicator is above the second threshold value at the first set of coordinates x₁.

In the positive case (YES in step 14), in step 15, a set of adjacent coordinates with the highest first gradient is determined. Indeed, if the value of the second performance indicator is satisfactory, i.e., above the threshold, it can be tried to move into a direction in which the first performance indicator increases. Thus, within the coordinate system for the first performance indicator, a set of coordinates adjacent to x₁ is chosen for which the first performance indicator increases most with respect to its value at x₁. Step 15 is reiterated as long as the first gradient is positive and until a set of coordinates is found for which the second performance indicator is above the second threshold and the first performance indicator is above the first threshold.

In the negative case (NO in step 14), i.e., if the second performance indicator is below the second threshold value at the first set of coordinates x₁, in step 16, a set of adjacent coordinates with the highest second gradient is determined. Thus, within the coordinate system for the second performance indicator, a set of coordinates adjacent to x₁ is chosen for which the second performance indicator increases most with respect to its value at x₁, allowing moving into a direction in which the second performance indicator is likely to be above the second threshold. Step 16 is reiterated as long as the second gradient is positive and until a set of coordinates is found for which the first performance indicator is above the first threshold and the second performance indicator is above the second threshold.

The steps between adjacent coordinates may be, for example, of 3° and 0.5 dB, respectively.

The decisions if, for a set of coordinates x', the first performance indicator is above the first threshold and the second performance indicator is above the second threshold, are taken in steps 18 and 17, respectively.

If, in step 17, it is decided that the second performance indicator is below the second threshold (NO in step 17), this means that no set of coordinates with a satisfactory second performance indicator could be found. In this case, in step 19, a new set of initial coordinates x₁, x₂, x₃, and x₄ is chosen, and the steps described hereinabove are repeated.

If, in step 17, it is decided that the second performance indicator is above the second threshold for the set of coordinates x' (YES in step 17) and thus satisfactory, it is subsequently decided, in step 18, if the first performance indicator is above the first threshold.

In the positive case (YES in step 18), the corresponding set of coordinates x' is recorded, i.e., it is stored in the lookup table mentioned previously in step 20 as a tuning set.

In the negative case (NO in step 18), i.e., if no set of coordinates with a satisfactory second performance indicator could be found, a new set of initial coordinates x₁, x₂, x₃, and x₄ is chosen in step 19, and the steps described hereinabove are repeated.

According to some embodiments, the first performance indicator may be the amplification efficiency of the Doherty amplifier, and the second performance indicator may be its linearity. In other embodiments, the first performance indicator may be the peak output power and the second performance indicator may be the amplification efficiency. The linearity of the Doherty amplifier may be expressed as the inverse of the adjacent channel leakage ratio (ACLR), or as the inverse of the spectral emission mask (SEM) value at a defined offset from the signal frequency.

In some embodiments, a third performance indicator is taken into account in addition to the first and second performance indicators. The reiterating steps described above are thus performed as long as a third gradient is positive and until a set of coordinates is found for which the third performance indicator is above a third threshold. This means that the steps 15 and 16 of Fig. 3 are reiterated while taking into account the three performance indicators, and the found tuning set is the set of coordinates for which the three performance indicators are simultaneously optimized.

In these embodiments, first performance indicator may be the peak output power, the second performance indicator may be the amplification efficiency, and the third performance indicator may be the linearity of the Doherty amplifier. Typically, the peak output power and the linearity are linked such that at high peak output powers, the linearity of the amplifier is improved (i.e., ACLR or SEM values are low). Therefore, if, for example, one of the gradients is not exploitable, the other one may be used for the search of the tuning set. Further, if for a set of coordinates the peak output power gradient is satisfactory but the linearity gradient is not (e.g., linearity varies too abruptly), then this set of coordinates is rejected because the digital predistortion means of the Doherty amplifier might not be able to linearize the amplifier.

The term "threshold" as used herein is to be understood as a target, i.e., a limit value that is needed to be met by the design of the amplifier.

The thresholds of the performance indicators may be determined in different ways.

First, the linearity threshold may be issued from a standard recommendation. For example, the 3GPP UTRA recommendation states that the SEM value must be below -13 dBm in 1 MHz resolution bandwidth at an offset of 4 MHz from the center frequency. The linearity threshold further depends on the design of the Doherty amplifier, such as the hardware structure and the DPD performances. The peak output power threshold is linked to the SEM threshold value since the peak output power capabilities of the Doherty amplifier are linked to the SEM value (high peak output power implies poor linearity). The peak output power threshold further depends on the amplifier design. Its value is given by the peak-to-average (PAR) signal ratio and the power amplifier average output power (rms). For example, for a 45 W rms signal (corresponding to 46.5 dBm) and a PAR signal of 6.5 dB the peak output power threshold will have to be set to 53 dBm (46,5+6.5) as a minimum. In order to obtain these values, the performance (e.g., the three performance indicators) of the Doherty amplifier may be calculated during the design phase for different phase and amplitude differences. An example of a plot obtained for the peak output power Pₒᵤₜ (measured for a frequency of 2620 MHz) is shown in Fig. 5. A graphical analysis may then be conducted in order to estimate the design capabilities of the Doherty amplifier and to identify design limits. This also allows restricting the tuning ranges in order, for example, to avoid tuning sets for which the DPD could not converge.

Second, the thresholds of the performance indicators may also be defined by specific application requirements. As such, the thresholds may be defined by the product line manager. For example, the efficiency threshold may be required to be 45%.

As stated above, the steps of determining the tuning set (step 10) and storing them in a lookup table (step 20) are performed at the conception/production stage of the Doherty amplifier, whereas the automatic setting step 30 is performed during operation of the Doherty amplifier so as to adaptively apply the correct settings during operation as described above.

Advantageously, the steps of determining the tuning set (step 10) and storing them in a lookup table (step 20), in addition to the automatic setting step 30, may also be implemented within the Doherty amplifier itself. The method steps may be performed, for example, by the microcontroller of the Doherty amplifier 1. This onboard solution advantageously allows for updating the lookup table 100 regularly, e.g., by creating and storing a new lookup table 100, and, in particular, for economically reconfiguring the Doherty amplifier 1 for new signal modes.

Advantages of embodiments of the present disclosure include the following. The method and the Doherty amplifier of the present invention provide for optimized operation of the Doherty amplifier thanks to the adaptive tuning of the amplifications paths. The method and the Doherty amplifier of the present disclosure allow for the maximization of efficiency, peak output power, and linearity, by compensating for phase and amplitude difference drift between the main and auxiliary amplification paths. Efficiency and linearity of the Doherty amplifier are thus improved despite possible frequency, power, or temperature variations. Therefore, design margins of the analog parts can be reduced and manufacturing yield improved since component tolerances, such as those of the employed transistors, do not need to be compensated no longer by the amplitude and phase difference settings. The method according to the present disclosure is flexible whatever the Doherty structure (symmetric, asymmetric, or hybrid Doherty architecture). The process of determining the tuning sets requires only few measuring points and is thus fast. Further, only few frequencies (for example, bottom, middle, top frequency) and a reduced average output power range are sufficient in order to extrapolate the correct settings for all operating configurations that will be used by the system implanting the Doherty amplifier. Since the operation is always optimized, damage of analog parts, e.g., the transistors, can be avoided.

The method according to the present disclosure may not only concern the operation of a Doherty amplifier, but it can also be applied to any power amplifier having two or more Tx chains in parallel in front of the output coupling. The tuning set allows for optimization of efficiency, peak output power, and linearity of several power amplifier architectures (e.g., balanced, LINC (Linear Amplification with Nonlinear Components), or multilevel LINC).

A person skilled in the art would readily recognize that steps of embodiments of the above-described method can be performed by programmed computers. Herein, some embodiments are intended to cover program storage devices, e.g., digital data storage media, which are machine-executable and encode machine-executable or computer-executable programs of instructions where said instructions perform some or all of the steps of methods described herein. The program storage devices may be, e.g., digital memories, magnetic storage media such as magnetic discs or tapes, hard drives, or optically readable digital storage media. The embodiments are also intended to cover computers programmed to perform said steps of methods described herein. It will be appreciated by the skilled person that the flow charts and diagrams of the Figures represent embodiments of processes which may be substantially represented in a computer readable medium and so executed by a computer or processor, even if such computer or processor is not explicitly shown.

Although some embodiments of the present invention have been illustrated in the accompanying Drawings and described in the foregoing Detailed Description, it should be understood that the present invention is not limited to the disclosed embodiments, but is capable of numerous rearrangements, modifications and substitutions without departing from the invention as set forth and defined by the following claims.

## Claims

1. A method for optimizing operation of a Doherty amplifier (1), the Doherty amplifier (1) comprising a main amplification path (2) and an auxiliary amplification path (3) and being adapted to receive an input signal (5) and split the signal (5) between the main and the auxiliary amplification paths (2, 3) such that the split signals have amplitude and phase differences with respect to each other, the method comprising the steps of:
i) determining (10) tuning sets for several frequency values and several average output power values, each tuning set comprising an amplitude difference and a phase difference for which at least a first and a second performance indicator of the Doherty amplifier (1) are simultaneously optimized;
ii) storing (20) the determined tuning sets in a lookup table in the Doherty amplifier (1); and
iii) automatically setting (30) the phase and amplitude differences between the main and auxiliary amplification paths (2, 3) during operation of the Doherty amplifier (1) using a stored tuning set corresponding to the input signal frequency and a requested average output power.

2. The method according to claim 1, wherein step i) comprises:
iv) measuring (12) values of the first and second performance indicator at sets of coordinates in a system (25) having a phase difference axis (26) and an amplitude difference axis (27), wherein a set of coordinates is chosen in the center of each of the four quadrants of the system (25);
v) determining (13), from the four sets of coordinates, a first set of coordinates with the maximum first performance indicator;
vi) determining a first and a second gradient (28a-28d) of the first and second performance indicators, respectively, between the sets of coordinates along the amplitude and phase difference axes (26, 27);
vii) if the second performance indicator is below a second threshold value at the first set of coordinates, determining (16) a set of adjacent coordinates with the highest second gradient;
viii) reiterating step vii) as long as the second gradient is positive and until a set of coordinates is found for which the first performance indicator is above a first threshold and the second performance indicator is above the second threshold;
ix) if the second performance indicator is above the second threshold value at the first set of coordinates, determining (15) a set of adjacent coordinates with the highest first gradient; and
x) reiterating step ix) as long as the first gradient is positive and until a set of coordinates is found for which the first performance indicator is above the first threshold and the second performance indicator is above the second threshold.

3. The method according to claim 1 or 2, wherein the first performance indicator is the amplification efficiency and the second performance indicator is the linearity of the Doherty amplifier (1).

4. The method according to any of claims 1 to 3, wherein the first performance indicator is the peak output power and the second performance indicator is the amplification efficiency of the Doherty amplifier (1).

5. The method according to claim 2, further comprising:
xi) determining a third gradient of the third performance indicator between the sets of coordinates along the amplitude and phase difference axes;
wherein steps viii) and x) are performed as long as the third gradient is positive and until a set of coordinates is found for which the third performance indicator is above a third threshold.

6. The method according to claim 5, wherein the first performance indicator is the peak output power, the second performance indicator is the amplification efficiency, and the third performance indicator is the linearity of the Doherty amplifier (1).

7. The method according to claim 3 or 6, wherein the linearity is expressed by the inverse of one of the adjacent channel leakage ratio and the spectral emission mask value at a defined offset from the signal frequency.

8. A Doherty amplifier (1) for amplifying an input signal (5), comprising:
- a main amplification path (2), an auxiliary amplification path (3), and splitting means (4) configured to split the input signal (5) between the main and the auxiliary amplification paths (2, 3) such that the split signals have amplitude and phase differences with respect to each other;
- a lookup table storing tuning sets for several frequency values and several average output power values, each tuning set comprising an amplitude difference and a phase difference for which at least a first performance indicator and a second performance indicator are simultaneously optimized; and
- control means (8, 9a, 9b) for automatically setting the phase and amplitude differences between the main and auxiliary amplification paths (2, 3) during operation of the Doherty amplifier (1) using a stored tuning set corresponding to the input signal frequency and a requested average output power.

9. The Doherty amplifier (1) according to claim 8, wherein the control means (8) are configured to:
i) measure values of the first and second performance indicators at sets of coordinates in a system ()25 having a phase difference axis (26) and an amplitude difference axis (27), wherein a set of coordinates is chosen in the center of each of the four quadrants of the system (25);
ii) determine, from the four sets of coordinates, a first set of coordinates with the maximum first performance indicator;
iii) determine a first and a second gradient (28a-28d) of the first and second performance indicators, respectively, between the sets of coordinates along the amplitude and phase difference axes (26, 27);
iv) if the second performance indicator is below a second threshold value at the first set of coordinates, determine a set of adjacent coordinates with the highest second gradient;
v) reiterate step iv) as long as the second gradient is positive and until a set of coordinates is found for which the first performance indicator is above a first threshold and the second performance indicator is above the second threshold;
vi) if the second performance indicator is above the second threshold value at the first set of coordinates, determine a set of adjacent coordinates with the highest first gradient; and
vii) reiterate step vi) as long as the first gradient is positive and until a set of coordinates is found for which the first performance indicator is above the first threshold and the second performance indicator is above the second threshold.

10. The Doherty amplifier (1) according to claim 8 or 9, wherein the first performance indicator is the amplification efficiency and the second performance indicator is the linearity of the Doherty amplifier (1).

11. The Doherty amplifier (1) according to any of claims 8 to 10, wherein the first performance indicator is the peak output power and the second performance indicator is the amplification efficiency of the Doherty amplifier (1).

12. The Doherty amplifier (1) according to claim 9, wherein the control means (8) are further configured to:
- determine a third gradient of the third performance indicator between the sets of coordinates along the amplitude and phase difference axes;
wherein the control means (8) are configured to perform steps v) and vii) as long as the third gradient is positive and until a set of coordinates is found for which the third performance indicator is above a third threshold.

13. The Doherty amplifier (1) according to claim 12, wherein the first performance indicator is the peak output power, the second performance indicator is the amplification efficiency, and the third performance indicator is the linearity of the Doherty amplifier (1).

14. The Doherty amplifier (1) according to claim 10 or 13, wherein the linearity is expressed by the inverse of one of the adjacent channel leakage ratio and the spectral emission mask value at a defined offset from the signal frequency.

## Amended claims

### Amended claims in accordance with Rule 137(2) EPC.

1. A method for optimizing operation of a Doherty amplifier (1), the Doherty amplifier (1) comprising a main amplification path (2) and an auxiliary amplification path (3) and being adapted to receive an input signal (5) and split the signal (5) between the main and the auxiliary amplification paths (2, 3) such that the split signals have amplitude and phase differences with respect to each other, the method comprising the steps of:
i) determining (10) tuning sets for several frequency values and several average output power values, each tuning set comprising an amplitude difference and a phase difference for which at least a first and a second performance indicator of the Doherty amplifier (1) are simultaneously optimized;
ii) storing (20) the determined tuning sets in a lookup table in the Doherty amplifier (1); and
iii) automatically setting (30) the phase and amplitude differences between the main and auxiliary amplification paths (2, 3) during operation of the Doherty amplifier (1) using a stored tuning set corresponding to the input signal frequency and a requested average output power,
wherein step i) comprises:
iv) measuring (12) values of the first and second performance indicator at sets of coordinates in a system (25) having a phase difference axis (26) and an amplitude difference axis (27), wherein a set of coordinates is chosen in the center of each of the four quadrants of the system (25);
v) determining (13), from the four sets of coordinates, a first set of coordinates with the maximum first performance indicator;
vi) determining a first and a second gradient (28a-28d) of the first and second performance indicators, respectively, between the sets of coordinates along the amplitude and phase difference axes (26, 27);
vii) if the second performance indicator is below a second threshold value at the first set of coordinates, determining (16) a set of adjacent coordinates with the highest second gradient;
viii) reiterating step vii) as long as the second gradient is positive and until a set of coordinates is found for which the first performance indicator is above a first threshold and the second performance indicator is above the second threshold;
ix) if the second performance indicator is above the second threshold value at the first set of coordinates, determining (15) a set of adjacent coordinates with the highest first gradient; and
x) reiterating step ix) as long as the first gradient is positive and until a set of coordinates is found for which the first performance indicator is above the first threshold and the second performance indicator is above the second threshold.

2. The method according to claim 1, wherein the first performance indicator is the amplification efficiency and the second performance indicator is the linearity of the Doherty amplifier (1).

3. The method according to claim 1 or 2, wherein the first performance indicator is the peak output power and the second performance indicator is the amplification efficiency of the Doherty amplifier (1).

4. The method according to claim 1, further comprising:
xi) determining a third gradient of the third performance indicator between the sets of coordinates along the amplitude and phase difference axes;
wherein steps viii) and x) are performed as long as the third gradient is positive and until a set of coordinates is found for which the third performance indicator is above a third threshold.

5. The method according to claim 4, wherein the first performance indicator is the peak output power, the second performance indicator is the amplification efficiency, and the third performance indicator is the linearity of the Doherty amplifier (1).

6. The method according to claim 2 or 5, wherein the linearity is expressed by the inverse of one of the adjacent channel leakage ratio and the spectral emission mask value at a defined offset from the signal frequency.

7. A Doherty amplifier (1) for amplifying an input signal (5), comprising:
- a main amplification path (2), an auxiliary amplification path (3), and splitting means (4) configured to split the input signal (5) between the main and the auxiliary amplification paths (2, 3) such that the split signals have amplitude and phase differences with respect to each other;
- a lookup table storing tuning sets for several frequency values and several average output power values, each tuning set comprising an amplitude difference and a phase difference for which at least a first performance indicator and a second performance indicator are simultaneously optimized; and
- control means (8, 9a, 9b) for automatically setting the phase and amplitude differences between the main and auxiliary amplification paths (2, 3) during operation of the Doherty amplifier (1) using a stored tuning set corresponding to the input signal frequency and a requested average output power,
wherein the control means (8) are configured to:
i) measure values of the first and second performance indicators at sets of coordinates in a system ()25 having a phase difference axis (26) and an amplitude difference axis (27), wherein a set of coordinates is chosen in the center of each of the four quadrants of the system (25);
ii) determine, from the four sets of coordinates, a first set of coordinates with the maximum first performance indicator;
iii) determine a first and a second gradient (28a-28d) of the first and second performance indicators, respectively, between the sets of coordinates along the amplitude and phase difference axes (26, 27);
iv) if the second performance indicator is below a second threshold value at the first set of coordinates, determine a set of adjacent coordinates with the highest second gradient;
v) reiterate step iv) as long as the second gradient is positive and until a set of coordinates is found for which the first performance indicator is above a first threshold and the second performance indicator is above the second threshold;
vi) if the second performance indicator is above the second threshold value at the first set of coordinates, determine a set of adjacent coordinates with the highest first gradient; and
vii) reiterate step vi) as long as the first gradient is positive and until a set of coordinates is found for which the first performance indicator is above the first threshold and the second performance indicator is above the second threshold.

8. The Doherty amplifier (1) according to claim 7, wherein the first performance indicator is the amplification efficiency and the second performance indicator is the linearity of the Doherty amplifier (1).

9. The Doherty amplifier (1) according to claims 7 or 8, wherein the first performance indicator is the peak output power and the second performance indicator is the amplification efficiency of the Doherty amplifier (1).

10. The Doherty amplifier (1) according to claim 7, wherein the control means (8) are further configured to:
- determine a third gradient of the third performance indicator between the sets of coordinates along the amplitude and phase difference axes;
wherein the control means (8) are configured to perform steps v) and vii) as long as the third gradient is positive and until a set of coordinates is found for which the third performance indicator is above a third threshold.

11. The Doherty amplifier (1) according to claim 10, wherein the first performance indicator is the peak output power, the second performance indicator is the amplification efficiency, and the third performance indicator is the linearity of the Doherty amplifier (1).

12. The Doherty amplifier (1) according to claim 8 or 11, wherein the linearity is expressed by the inverse of one of the adjacent channel leakage ratio and the spectral emission mask value at a defined offset from the signal frequency.
